(19) Europäisches Patentamt
European Patent Office
Office européen des brevets

(11) **EP 3 435 171 B1**

(12) **FASCICULE DE BREVET EUROPEEN**

(45) Date de publication et mention
de la délivrance du brevet:
**25.08.2021 Bulletin 2021/34**

(51) Int Cl.:
**G04B 17/04** *(2006.01)*          **G04B 31/02** *(2006.01)*
**B81B 3/00** *(2006.01)*

(21) Numéro de dépôt: **18185137.9**

(22) Date de dépôt: **24.07.2018**

(54) **OSCILLATEUR D'HORLOGERIE A GUIDAGES FLEXIBLES A GRANDE COURSE ANGULAIRE**

UHRWERKOSZILLATOR MIT FLEXIBLEN FÜHRUNGEN MIT GROSSER WINKELFÖRMIGER LAUFBAHN

TIMEPIECE OSCILLATOR HAVING FLEXIBLE GUIDES WITH WIDE ANGULAR TRAVEL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.07.2017 EP 17183666**
**25.06.2018 EP 18179623**

(43) Date de publication de la demande:
**30.01.2019 Bulletin 2019/05**

(73) Titulaire: **The Swatch Group Research and Development Ltd**
**2074 Marin (CH)**

(72) Inventeurs:
• **Di Domenico, Gianni**
**2000 Neuchâtel (CH)**
• **Cusin, Pierre**
**1423 Villars-Burquin (CH)**
• **Helfer, Jean-Luc**
**2525 Le Landeron (CH)**
• **Gandelhman, Alex**
**2000 Neuchâtel (CH)**
• **Winkler, Pascal**
**2072 St-Blaise (CH)**
• **Hinaux, Baptiste**
**1005 Lausanne (CH)**
• **Léchot, Dominique**
**2722 Les Reussilles (CH)**
• **Matthey, Olivier**
**1422 Grandson (CH)**
• **Klinger, Laurent**
**2503 Bienne (CH)**
• **Favre, Jérôme**
**2000 Neuchâtel (CH)**

(74) Mandataire: **ICB SA**
**Faubourg de l'Hôpital, 3**
**2001 Neuchâtel (CH)**

(56) Documents cités:
**EP-A1- 2 911 012          EP-A2- 2 998 800**
**WO-A1-2016/124436    CH-A2- 713 151**
**US-A- 3 628 781**

**Description**

<u>Domaine de l'invention</u>

L'invention concerne un oscillateur mécanique d'horlogerie, comportant un premier élément support rigide, un deuxième élément inertiel massif, et, entre ledit premier élément support rigide et ledit deuxième élément inertiel massif plus de deux premières lames flexibles qui supportent ledit deuxième élément inertiel massif et sont agencées pour le rappeler vers une position de repos, ledit deuxième élément inertiel massif étant agencé pour osciller angulairement selon un plan d'oscillation autour de ladite position de repos, lesdites deux premières lames flexibles ne se touchant pas et leurs projections sur ledit plan d'oscillation se croisant, en position de repos, en un point de croisement, au voisinage immédiat duquel ou par lequel passe l'axe de rotation dudit deuxième élément inertiel massif perpendiculairement audit plan d'oscillation, et les encastrements desdites premières lames flexibles avec ledit premier élément support rigide et ledit deuxième élément inertiel massif définissant deux directions de lames parallèles audit plan d'oscillation.

L'invention concerne encore un mouvement d'horlogerie comportant au moins un tel oscillateur mécanique.

L'invention concerne encore une montre comportant un tel mouvement d'horlogerie.

L'invention concerne le domaine des oscillateurs mécaniques d'horlogerie comportant des guidages à lames flexibles assurant les fonctions de maintien et de rappel d'éléments mobiles.

<u>Arrière-plan de l'invention</u>

L'utilisation de guidages flexibles, notamment à lames souples, dans des oscillateurs mécaniques d'horlogerie, est rendue possible par des procédés d'élaboration, tels que « MEMS », « LIGA » ou similaires, de matériaux micro-usinables, tels que le silicium et ses oxydes, qui permettent une fabrication très reproductible de composants qui présentent des caractéristiques élastiques constantes dans le temps et une grande insensibilité aux agents extérieurs tels que température et humidité. Des pivots à guidage flexible, tels que décrits dans les demandes EP1419039 ou EP16155039 du même déposant, permettent notamment de remplacer le pivot d'un balancier classique, ainsi que le ressort-spiral qui lui est usuellement associé. La suppression des frottements de pivots permet d'augmenter substantiellement le facteur de qualité d'un oscillateur. Toutefois les pivots à guidage flexible ont généralement une course angulaire faible, de l'ordre de 10° à 20°, ce qui est très faible en comparaison de l'amplitude usuelle de 300° d'un balancier-spiral, et qui n'autorise pas leur combinaison directe avec des mécanismes d'échappement classiques, et notamment avec des arrêtoirs usuels tels qu'une ancre suisse ou similaire, qui exigent une grande course angulaire pour assurer leur bon fonctionnement.

Lors du Congrès de Chronométrie de Montreux, Suisse, des 28 et 29 septembre 2016, l'équipe de M. H. Kahrobaiyan a abordé l'augmentation de cette course angulaire dans l'article « Gravity insensitive flexure pivots for watch oscillators », et il apparaît que la solution -complexe- envisagée n'est pas isochrone.

Le document EP3035127A1 au nom du même déposant SWATCH GROUP RESEARCH & DEVELOPMENT Ltd décrit un oscillateur d'horlogerie comportant une base de temps avec au moins un résonateur constitué par un diapason lequel comporte au moins deux parties mobiles oscillantes, lesdites parties mobiles étant fixées à un élément de liaison, que comporte ledit oscillateur, par des éléments flexibles dont la géométrie détermine un axe de pivotement virtuel de position déterminée par rapport audit élément de liaison, autour duquel axe de pivotement virtuel oscille ladite partie mobile respective, dont le centre de masse est confondu en position de repos avec ledit axe de pivotement virtuel respectif. Pour au moins une dite partie mobile lesdits éléments flexibles sont constitués de lames élastiques croisées et s'étendant à distance l'une de l'autre dans deux plans parallèles, et dont les projections des directions sur un desdits plans parallèles se croisent au niveau dudit axe de pivotement virtuel, de ladite partie mobile considérée.

Le document US3628781A au nom de GRIB décrit une fourche de diapason, sous la forme d'une structure en porte-à-faux double, pour permettre un mouvement de rotation accentué d'une paire d'éléments mobiles, par rapport à un plan de référence fixe comprenant un premier corps élastiquement déformable ayant au moins deux parties flexibles allongées élastiquement similaires, les extrémités de chacune desdites parties flexibles étant respectivement solidaire de parties rigides agrandies dudit élément, la première desdites parties rigides étant fixée pour définir un plan de référence et la seconde étant supportée élastiquement pour avoir un mouvement de rotation accentué par rapport à la première, un second corps déformable élastiquement sensiblement identique au premier corps déformable élastiquement, et des moyens pour fixer rigidement les premières desdites parties rigides respectives desdits corps élastiquement déformables en relation espacée pour fournir une structure de fourche de diapason dans laquelle chacune des dents du diapason comprend l'extrémité libre de l'un desdits corps élastiquement déformables.

Le document EP2911012A1 au nom de CSEM décrit un oscillateur rotatif pour pièce d'horlogerie comprenant un élément de support destiné à permettre l'assemblage de l'oscillateur sur une pièce d'horlogerie, un balancier, une pluralité de lames flexibles reliant l'élément de support au balancier et aptes à exercer un couple de rappel sur le balancier, une serge montée solidaire du balancier, la pluralité de lames flexibles comportant au moins deux lames flexibles dont une première lame disposée dans un premier plan perpendiculaire au plan de l'oscillateur, et une deuxième lame disposée dans un deuxième plan perpendiculaire au plan de l'oscillateur et sécant avec le premier plan. Les première et deuxième lames sont de géométrie identique, et l'axe géométrique d'oscillation de l'oscillateur est défini par l'intersection du premier plan et du deuxième plan, cet axe géométrique d'oscillation croisant les première et deuxième lames aux 7/8ème de leur longueur respective.

Le document EP2998800A2 au nom de PATEK PHILIPPE décrit un composant horloger à pivot flexible, comprenant une première pièce monolithique définissant une première partie rigide et une deuxième partie rigide reliées par au moins une première lame élastique, et une deuxième pièce monolithique définissant une troisième partie rigide et une quatrième partie rigide reliées par au moins une deuxième lame élastique, les première et deuxième pièces monolithiques étant assemblées l'une à l'autre de telle sorte que les première et troisième parties rigides soient solidaires l'une de l'autre, les deuxième et quatrième parties rigides soient solidaires l'une de l'autre. La au moins une première lame élastique et la au moins une deuxième lame élastique se croisent sans contact et définissent un axe de rotation virtuel pour les deuxième et quatrième parties rigides, par rapport aux première et troisième parties rigides. Ce composant comprend un palier, solidaire des deuxième et quatrième parties rigides, et destiné à guider la rotation d'un élément mobile autour d'un axe distinct de l'axe de rotation virtuel et sensiblement parallèle à ce dernier.

Le document EP3130966A1 au nom de ETA Manufacture Horlogère Suisse décrit un mouvement d'horlogerie mécanique qui comprend au moins un barillet, un ensemble de roues d'engrenage entraîné à une extrémité par le barillet, et un mécanisme d'échappement d'un oscillateur local avec un résonateur sous forme d'un balancier-spiral et un système de rétroaction du mouvement d'horlogerie. Le mécanisme d'échappement est entraîné à une autre extrémité de l'ensemble de roues d'engrenage. Le système de rétroaction comprend au moins un oscillateur de référence précis, combiné à un comparateur de marche pour comparer la marche des deux oscillateurs, et un mécanisme de réglage du résonateur de l'oscillateur local pour ralentir ou accélérer le résonateur sur la base d'un résultat de la comparaison dans le comparateur de marche.

Le document CH709536A2 au nom de ETA Manufacture Horlogère Suisse décrit un mécanisme régulateur d'horlogerie comportant, montés mobiles, au moins en pivotement par rapport à une platine, une roue d'échappement agencée pour recevoir un couple moteur via un rouage, et un premier oscillateur comportant une première structure rigide reliée à ladite platine par des premiers moyens de rappel élastique. Ce mécanisme régulateur comporte un deuxième oscillateur comportant une deuxième structure rigide reliée à ladite première structure rigide par des deuxièmes moyens de rappel élastique, et qui comporte des moyens de guidage agencés pour coopérer avec des moyens de guidage complémentaire que comporte ladite roue d'échappement, synchronisant ledit premier oscillateur et ledit deuxième oscillateur avec ledit rouage.

La demande de brevet EP17183666 du même déposant, décrit un pivot à grande course angulaire. En utilisant un angle entre les lames d'environ 25° à 30°, et un point de croisement situé à environ 45% de leur longueur, et en introduisant un décalage du centre de masse du résonateur par rapport à l'axe de rotation, il est possible d'obtenir simultanément un bon isochronisme et une insensibilité aux positions sur une grande course angulaire (jusqu'à 40° ou plus). Afin de maximiser la course angulaire tout en conservant une bonne rigidité hors plan, on tend à affiner les lames tout en augmentant leur hauteur. L'utilisation d'une grande valeur du rapport d'aspect, c'est-à-dire du rapport entre la hauteur de la lame sur son épaisseur est théoriquement avantageuse, mais dans la pratique on observe que pour de grandes amplitudes angulaires il se produit une inhibition de la courbure anticlastique, qui altère les propriétés d'isochronisme du résonateur.

Le document WO2016/124436A1 au nom de ETA Manufacture Horlogère Suisse décrit un mécanisme oscillateur monolithique doté de lames élastiques qui sont au moins cinq fois plus hautes qu'épaisses.

## Résumé de l'invention

L'invention se propose de mettre au point un oscillateur mécanique à guidages flexibles, dont la course angulaire soit compatible avec des mécanismes d'échappement existants, et dont les guidages flexibles se comportent de façon régulière quelle que soit leur déformation.

Ce résonateur à guidage flexible en rotation doit posséder les propriétés suivantes :

-　un facteur de qualité élevé ;
-　une grande course angulaire ;
-　un bon isochronisme ;
-　une grande insensibilité aux positions dans l'espace.

En considérant le cas particulier d'un guidage flexible à lames croisées en projection dans un plan parallèle au plan d'oscillation, où ces lames joignent une masse fixe et une masse mobile, la course angulaire possible θ du pivot dépend du rapport X= D/L entre, d'une part la distance D du point d'encastrement d'une lame dans la masse fixe et le point de croisement, et d'autre part la longueur totale L de cette même lame, dans son élongation, entre ses deux encastrements opposés. Les travaux cités ci-dessus de l'équipe de M. H. Kahrobaiyan montrent que cette course angulaire possible θ est, pour un couple de lames donné et d'angle au sommet α donné au point de croisement, ici de 90°, maximale pour X= D/L= 0.5, et décroît rapidement quand on s'écarte de cette valeur, selon une courbe sensiblement symétrique. Or un tel pivot à lames croisées avec X= D/L= 0.5 et a=90° n'est pas isochrone.

L'invention explore de ce fait les domaines de combinaisons favorables entre les valeurs d'angle au sommet α au croisement des lames, et les valeurs du rapport X= D/L, pour obtenir des pivots isochrones, ainsi que les valeurs optimales du rapport d'aspect de chacune des lames.

A cet effet, l'invention concerne un oscillateur mécanique selon la revendication 1.

Et notamment l'invention montre que l'on peut obtenir un oscillateur isochrone avec des pivots qui vérifient à la fois les deux inégalités: 0.15S(X= D/L)S0.85, et a≤60°.

Naturellement les configurations avec a=0° sont écartées, les lames n'étant alors plus sécantes en projection, mais parallèles.

L'invention concerne encore un mouvement d'horlogerie comportant au moins un tel oscillateur mécanique.

L'invention concerne encore une montre comportant un tel mouvement d'horlogerie.

Description sommaire des dessins

D'autres caractéristiques et avantages de l'invention apparaîtront à la lecture de la description détaillée qui va suivre, en référence aux dessins annexés, où :

- la figure 1 représente, de façon schématisée, et en perspective, une première variante d'oscillateur mécanique, qui comporte un premier élément support rigide, de forme allongée, pour sa fixation à une platine du mouvement ou similaire, auquel est suspendu un deuxième élément inertiel massif par deux premières flexibles disjointes, croisées en projection sur le plan d'oscillation de ce deuxième élément inertiel, lequel coopère avec un mécanisme d'échappement classique avec ancre suisse et roue d'échappement standard ;
- la figure 2 représente, de façon schématisée, et en plan, l'oscillateur de la figure 1 ;
- la figure 3 représente, de façon schématisée, et en coupe passant par l'axe de croisement des lames, l'oscillateur de la figure 1 ;
- la figure 4 représente, de façon schématisée, un détail de la figure 2, montrant le décalage entre le croisement des lames et la projection du centre de masse du résonateur, ce détail avec décalage étant applicable de la même façon aux différentes variantes décrites ci-après;
- la figure 5 est un graphe, avec en abscisse rapport X= D/L entre, d'une part la distance D du point d'encastrement d'une lame dans la masse fixe et le point de croisement, et d'autre part la longueur totale L de cette même lame entre ses deux encastrements opposés, et en ordonnées l'angle au sommet de croisement des lames flexibles, et qui définit deux courbes, inférieure et supérieure, en trait interrompu, qui bornent le domaine convenable entre ces paramètres pour assurer l'isochronisme, la courbe en trait plein correspondant à une valeur avantageuse ;
- la figure 6 représente, de façon similaire à la figure 1, une deuxième variante d'oscillateur mécanique, où le premier élément support rigide, de forme allongée, est aussi mobile par rapport à une structure fixe, et est porté par un troisième élément rigide, par l'intermédiaire d'un second jeu de lames flexibles, agencées de façon similaire au premières lames flexibles, le deuxième élément inertiel étant encore agencé pour coopérer avec un mécanisme d'échappement classique non représenté ;
- la figure 7 représente, de façon schématisée, et en plan, l'oscillateur de la figure 6;
- la figure 8 représente, de façon schématisée, et en coupe passant par l'axe de croisement des lames, l'oscillateur de la figure 1 ;
- la figure 9 est un schéma-blocs représentant une montre qui comporte un mouvement avec un tel résonateur ;
- la figure 10 représente, de façon schématisée et en perspective, un guidage à lames flexibles croisées en projection, entre une structure fixe et un élément inertiel ;
- la figure 11 représente, de façon similaire à la figure 10, un guidage flexible théorique dont chaque lame a un rapport d'aspect supérieur à celui des lames de la figure 10 ;
- la figure 12 représente, de façon similaire à la figure 10, un guidage flexible selon l'invention, équivalent en termes de rappel élastique au guidage théorique de la figure 11, mais comportant un nombre supérieur de lames, dont chacune a un rapport d'aspect inférieur à 10, dans cette variante deux lames élémentaires d'un premier type sont superposées dans une première direction, et croisent en projection deux lames élémentaires d'un deuxième type qui sont aussi superposées entre elles et s'étendent dans une deuxième direction ;
- la figure 13 représente, de façon similaire à la figure 12, un autre guidage flexible selon l'invention, dont les quatre lames sont en quinconce ;

- la figure 14 représente, de façon similaire à la figure 12, encore un autre guidage flexible selon l'invention, dont les quatre lames comportent deux lames élémentaires d'un premier type dans une première direction, qui encadrent deux lames élémentaires d'un deuxième type qui sont superposées entre elles et s'étendent dans une deuxième direction ;
- la figure 15 représente, de façon similaire à la figure 12, un autre guidage flexible selon l'invention, comportant six lames superposées par trois ;
- la figure 16 représente, de façon similaire à la figure 13, un autre guidage flexible selon l'invention, dont les six lames sont en quinconce ;
- la figure 17 représente, de façon similaire à la figure 14, un autre guidage flexible selon l'invention, dont les huit lames comportent une première et une deuxième superposition de deux lames élémentaires d'un premier type dans une première direction, qui encadrent quatre lames élémentaires d'un deuxième type qui sont superposées entre elles et s'étendent dans une deuxième direction ;
- la figure 18 représente, de façon similaire à la figure 12, encore un autre guidage flexible selon l'invention, à nombre inégal de lames, dont les cinq lames comportent deux lames élémentaires d'un premier type dans une première direction, qui encadrent trois lames élémentaires d'un deuxième type qui sont superposées entre elles et s'étendent dans une deuxième direction.

Description détaillée des modes de réalisation préférés

L'invention concerne ainsi un oscillateur mécanique 100 d'horlogerie, comportant au moins un premier élément support rigide 4 et un deuxième élément inertiel massif 5. Cet oscillateur 100 comporte, entre le premier élément support rigide 4 et le deuxième élément inertiel massif 5, plus de deux premières lames flexibles 31, 32, qui supportent le deuxième élément inertiel massif 5, et qui sont agencées pour le rappeler vers une position de repos. Ce deuxième élément inertiel massif 5 est agencé pour osciller angulairement selon un plan d'oscillation autour de cette position de repos.

Les deux premières lames flexibles 31 et 32 ne se touchent pas, et, en position de repos, leurs projections sur le plan d'oscillation se croisent en un point de croisement P, au voisinage immédiat duquel ou par lequel passe l'axe de rotation du deuxième élément inertiel massif 5 perpendiculairement au plan d'oscillation. Tous les éléments géométriques décrits ci-après s'entendent, sauf mention contraire, comme étant considérés dans la position de repos de l'oscillateur à l'arrêt.

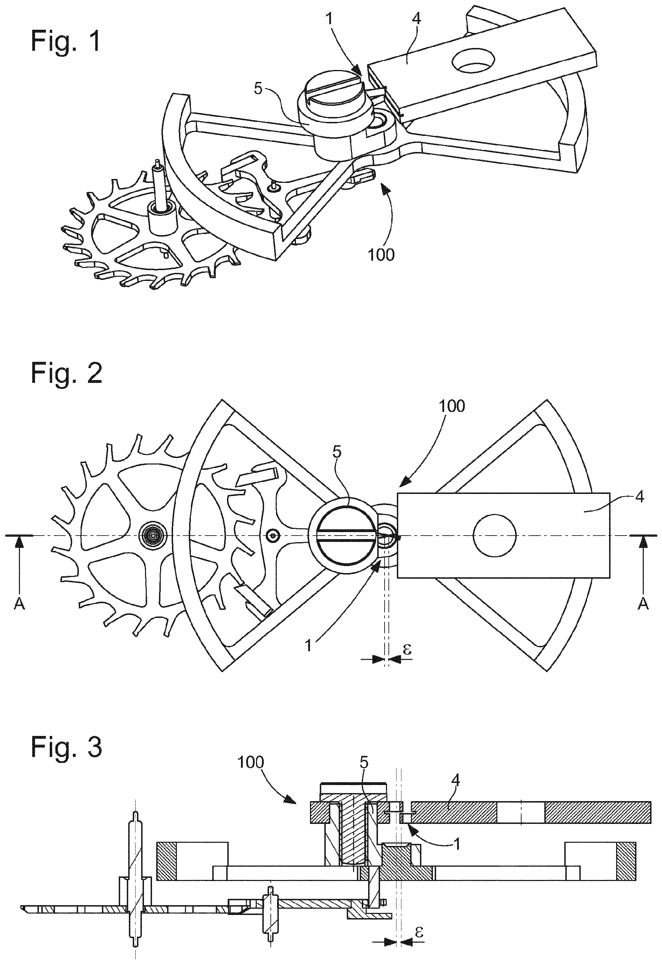

Les figures 1 à 4 illustrent une première variante avec un premier élément support rigide 4 et un deuxième élément inertiel massif reliés par deux premières lames flexibles 31, 32.

Les encastrements des premières lames flexibles 31, 32, avec le premier élément support rigide 4 et le deuxième élément inertiel massif 5 définissent deux directions de lames DL1, DL2, qui sont parallèles au plan d'oscillation et qui font entre elles, en projection sur le plan d'oscillation, un angle au sommet a.

La position du point de croisement P est définie par le rapport $X = D/L$ où D est la distance entre la projection, sur le plan d'oscillation, de l'un des points d'encastrement des premières lames 31, 32, dans le premier élément de support rigide 4 et le point de croisement P, et où L est la longueur totale de la projection, sur le plan d'oscillation, de la lame 31, 32, concernée. Et la valeur du rapport $D/L$ est comprise entre 0 et 1, et l'angle au sommet $\alpha$ est inférieur ou égal à 70°.

De façon avantageuse, à la fois l'angle au sommet $\alpha$ est inférieur ou égal à 60°, et, pour chaque première lame flexible 31, 32, le rapport d'encastrement $D1/L1$, $D2/L2$, est compris entre 0.15 et 0.85, bornes comprises.

De façon particulière, tel que visible sur les figures 2 à 4, le centre de masse de l'oscillateur 100 dans sa position de repos est distant du point de croisement P d'un écart $\varepsilon$ qui est compris entre 10% et 20% de la longueur totale L de la projection, sur le plan d'oscillation, de la lame 31, 32. Plus particulièrement encore, l'écart $\varepsilon$ est compris entre 12% et 18% de la longueur totale L de la projection, sur le plan d'oscillation, de la lame 31, 32.

Plus particulièrement, et tel qu'illustré sur les figures, les premières lames 31, 32, et leurs encastrements définissent ensemble un pivot 1 qui, en projection sur le plan d'oscillation, est symétrique par rapport à un axe de symétrie AA passant par le point de croisement P.

Plus particulièrement, quand le pivot 1 est symétrique par rapport à l'axe de symétrie AA, en position de repos, en projection sur le plan d'oscillation, le centre de masse du deuxième élément inertiel massif 5 est situé sur l'axe de symétrie AA du pivot 1. En projection, ce centre de masse peut être confondu ou non avec le point de croisement P.

Plus particulièrement encore, le centre de masse du deuxième élément inertiel massif 5 est situé à une distance non nulle du point de croisement P correspondant à l'axe de rotation du deuxième élément inertiel massif 5, tel que visible sur les figures 2 à 4.

De façon particulière, en projection sur le plan d'oscillation, le centre de masse du deuxième élément inertiel massif 5 est situé sur l'axe de symétrie AA du pivot 1, et est situé à distance non nulle du point de croisement P laquelle est comprise entre 0.1 fois et 0.2 fois la longueur totale L de la projection, sur le plan d'oscillation, de la lame 31, 32.

Plus particulièrement, les premières lames 31 et 32 sont des lames droites.

Plus particulièrement encore, l'angle au sommet $\alpha$ est inférieur ou égal à 50°, ou encore est inférieur ou égal à 40°, ou encore inférieur ou égal à 35°, ou encore inférieur ou égal à 30°.

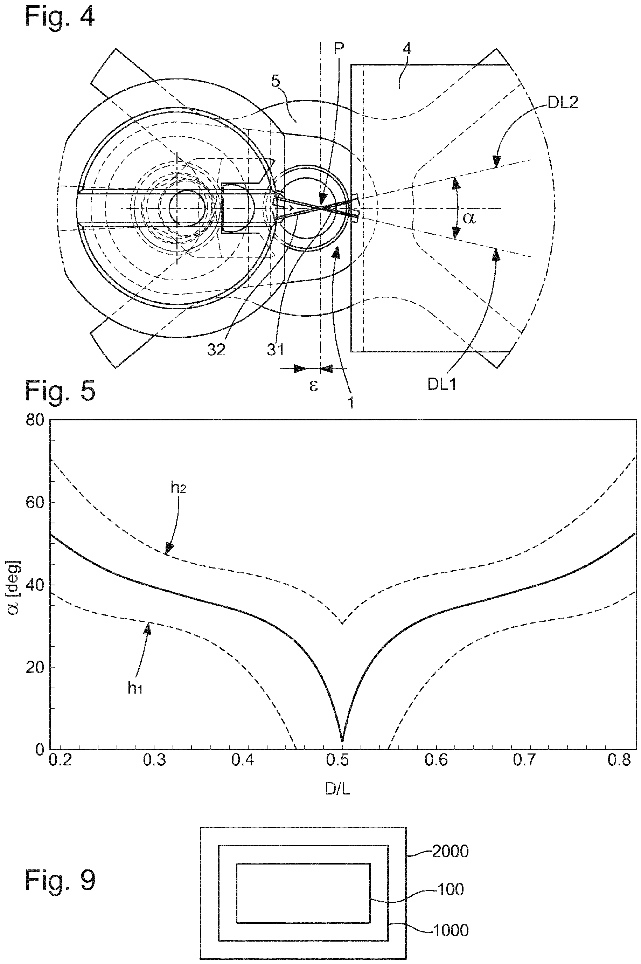

Plus particulièrement, le rapport d'encastrement D1/L1, D2/L2, est compris entre 0.15 et 0.49, bornes comprises, ou entre 0.51 et 0.85, bornes comprises, tel que visible sur la figure 5.

Dans une variante, et plus particulièrement selon l'exécution selon la figure 5, l'angle au sommet $\alpha$ est inférieur ou égal à 50°, et le rapport d'encastrement D1/L1, D2/L2, est compris entre 0.25 et 0.75, bornes comprises.

Dans une variante, et plus particulièrement selon l'exécution selon la figure 5, l'angle au sommet $\alpha$ est inférieur ou égal à 40°, et le rapport d'encastrement D1/L1, D2/L2, est compris entre 0.30 et 0.70, bornes comprises.

Dans une variante, et plus particulièrement selon l'exécution selon la figure 5, l'angle au sommet $\alpha$ est inférieur ou égal à 35°, et le rapport d'encastrement D1/L1, D2/L2, est compris entre 0.40 et 0.60, bornes comprises.

De façon avantageuse, et tel que visible sur la figure 5, l'angle au sommet $\alpha$ et le rapport X= D/L satisfont la relation :

$$h1(D/L) < \alpha < h2(D/L),$$

avec, pour

$$0.2 \leq X < 0.5 :$$

$$h1(X) = 116 - 473 \cdot (X + 0.05) + 3962 \cdot (X + 0.05)^3 - 6000 \cdot (X + 0.05)^4,$$

$$h2(X) = 128 - 473 \cdot (X - 0.05) + 3962 \cdot (X - 0.05)^3 - 6000 \cdot (X - 0.05)^4,$$

pour

$$0.5 < X \leq 0.8:$$

$$h1(X) = 116 - 473 \cdot (1.05 - X) + 3962 \cdot (1.05 - X)^3 - 6000 \cdot (1.05 - X)^4,$$

$$h2(X) = 128 - 473 \cdot (0.95 - X) + 3962 \cdot (0.95 - X)^3 - 6000 \cdot (0.95 - X)^4.$$

Plus particulièrement, et notamment dans l'exécution non limitative illustrée par les figures, les premières lames flexibles 31 et 32 ont la même longueur L, et la même distance D.

Plus particulièrement, entre leurs encastrements, ces premières lames flexibles 31 et 32 sont identiques.

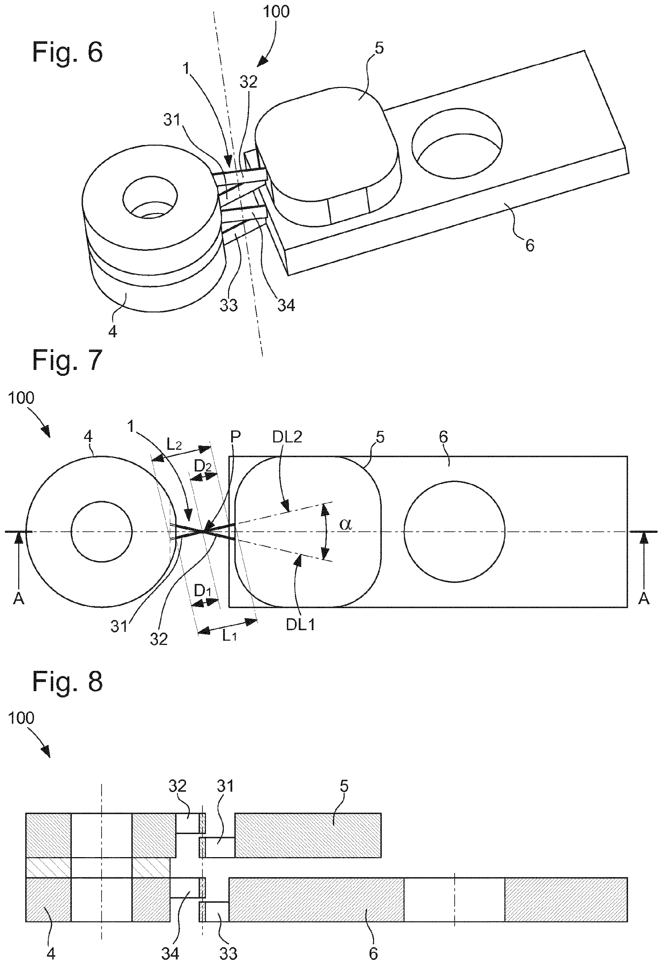

Les figures 6 à 8 illustrent une deuxième variante d'oscillateur mécanique 100, où le premier élément support rigide 4 est aussi mobile, directement ou indirectement par rapport à une structure fixe que comporte cet oscillateur 100, et est porté par un troisième élément rigide 6, par l'intermédiaire de deux secondes lames flexibles 33, 34, agencées de façon similaire au premières lames flexibles 31, 32.

Plus particulièrement, dans la réalisation non limitative illustrée par les figures, les projections des premières lames flexibles 31, 32, et des secondes lames flexibles 33, 34, sur le plan d'oscillation se croisent au même point de croisement P.

Dans une autre forme particulière d'exécution non illustrée, en position de repos, en projection sur le plan d'oscillation, les projections des premières lames flexibles 31, 32, et des secondes lames flexibles 33, 34, sur le plan d'oscillation se croisent en deux points distincts tous deux situés sur l'axe de symétrie AA du pivot 1, quand le pivot 1 est symétrique par rapport à l'axe de symétrie AA.

Plus particulièrement, les encastrements des secondes lames flexibles 33, 34, avec le premier élément support rigide 4 et le troisième élément rigide 6, définissent deux directions de lames parallèles au plan d'oscillation et faisant entre elles, en projection sur le plan d'oscillation, un angle au sommet de même bissectrice que l'angle au sommet $\alpha$ que les premières lames flexibles 31, 32. Plus particulièrement encore, ces deux directions des secondes lames flexibles 33, 34, présentent le même angle au sommet $\alpha$ que les premières lames flexibles 31, 32.

Plus particulièrement, les secondes lames flexibles 33, 34, sont identiques aux premières lames flexibles 31, 32, comme dans l'exemple non limitatif des figures.

Plus particulièrement, quand le pivot 1 est symétrique par rapport à l'axe de symétrie AA, en position de repos, en projection sur le plan d'oscillation, le centre de masse du deuxième élément inertiel massif 5 est situé sur l'axe de symétrie AA du pivot 1.

De façon similaire et particulière, quand le pivot 1 est symétrique par rapport à l'axe de symétrie AA, en position de repos, le centre de masse du premier élément support rigide 4 est situé, en projection sur le plan d'oscillation, sur l'axe de symétrie AA du pivot 1.

Dans une variante particulière, quand le pivot 1 est symétrique par rapport à l'axe de symétrie AA, en position de repos, en projection sur le plan d'oscillation, à la fois le centre de masse du deuxième élément inertiel massif 5 et le centre de masse du premier élément support rigide 4 sont situés sur l'axe de symétrie AA du pivot 1. Plus particulièrement encore, les projections du centre de masse du deuxième élément inertiel massif 5 et du centre de masse du premier élément support rigide 4, sur l'axe de symétrie AA du pivot 1, sont confondues.

Une configuration particulière illustrée par les figures pour de tels pivots superposés est celle où les projections des premières lames flexibles 31, 32, et des secondes lames flexibles 33, 34, sur le plan d'oscillation se croisent au même point de croisement P, qui correspond aussi à la projection du centre de masse du deuxième élément inertiel massif 5, ou du moins qui en est la plus proche possible. Plus particulièrement ce même point correspond aussi à la projection du centre de masse du premier élément support rigide 4. Plus particulièrement encore, ce même point correspond aussi à la projection du centre de masse de l'oscillateur 100 tout entier.

Dans une variante particulière de cette configuration de pivots superposés, quand le pivot 1 est symétrique par rapport à l'axe de symétrie AA, en position de repos, en projection sur le plan d'oscillation, le centre de masse du deuxième élément inertiel massif 5 est situé sur l'axe de symétrie AA du pivot 1, et à une distance non nulle du point de croisement correspondant à l'axe de rotation du deuxième élément inertiel massif 5, laquelle distance non nulle est comprise entre 0.1 fois et 0.2 fois la longueur totale L de la projection, sur le plan d'oscillation, de la lame 33, 34, avec un écart similaire à l'écart ε des figures 2 à 4.

De façon similaire et particulière, quand le pivot 1 est symétrique par rapport à l'axe de symétrie AA, le centre de masse du deuxième élément inertiel massif 5 est situé, en projection sur le plan d'oscillation, sur l'axe de symétrie AA du pivot 1 et à une distance non nulle du point de croisement correspondant à l'axe de rotation du premier élément support rigide 4 laquelle distance non nulle est comprise entre 0.1 fois et 0.2 fois la longueur totale L de la projection, sur le plan d'oscillation, de la lame 31, 32.

De façon similaire et particulière, quand le pivot 1 est symétrique par rapport à l'axe de symétrie AA, le centre de masse du premier élément support rigide 4 est situé, en projection sur le plan d'oscillation, sur l'axe de symétrie AA du pivot 1 et à une distance non nulle du point de croisement P correspondant à l'axe de rotation du deuxième élément inertiel massif 5. Notamment cette distance non nulle est comprise entre 0.1 fois et 0.2 fois la longueur totale L de la projection, sur le plan d'oscillation, de la lame 33, 34.

De façon similaire et particulière, quand le pivot 1 est symétrique par rapport à l'axe de symétrie AA, le centre de masse du premier élément support rigide 4 est situé, en projection sur le plan d'oscillation, sur l'axe de symétrie AA du pivot 1 et à une distance non nulle du point de croisement correspondant à l'axe de rotation du premier élément support rigide 4 laquelle distance non nulle est comprise entre 0.1 fois et 0.2 fois la longueur totale L de la projection, sur le plan d'oscillation, de la lame 31, 32.

De façon similaire et particulière, le centre de masse du premier élément support rigide 4 est situé sur l'axe de symétrie AA du pivot 1 et à la distance non nulle du point de croisement P laquelle est comprise entre 0.1 fois et 0.2 fois la longueur totale L de la projection, sur le plan d'oscillation, de la lame 33, 34.

Plus particulièrement, et tel que visible sur la variante des figures, quand le pivot 1 est symétrique par rapport à l'axe de symétrie AA, en projection sur le plan d'oscillation, le centre de masse de l'oscillateur 100 dans sa position de repos est situé sur l'axe de symétrie AA.

Plus particulièrement, le deuxième élément inertiel massif 5 est allongé selon la direction de l'axe de symétrie AA du pivot 1, quand le pivot 1 est symétrique par rapport à l'axe de symétrie AA. C'est par exemple le cas des figures 1 à 4 où l'élément inertiel 5 comporte une embase sur laquelle est fixé un balancier traditionnel à bras longs pourvus de tronçons de serge ou de masselottes en arc de cercle. L'objectif est de minimiser l'influence des accélérations angulaires externes autour de l'axe de symétrie du pivot, car les lames ont une faible rigidité en rotation autour de cet axe à cause du petit angle a.

L'invention se prête bien à une exécution monolithique des lames et des composants massifs qu'elles joignent, en matériau micro-usinable ou au moins partiellement amorphe, avec une mise en œuvre par procédé « MEMS » ou « LIGA » ou similaire. En particulier, dans le cas d'une exécution en silicium, l'oscillateur 100 est avantageusement compensé thermiquement par ajout de dioxyde de silicium sur des lames flexibles en silicium. Dans une variante, les lames peuvent être assemblées, par exemple encastrées dans des rainures, ou autre.

Lorsque on a deux pivots en série, comme dans le cas de figures 6 à 9, on peut mettre le centre de masse sur l'axe de rotation, dans le cas où l'agencement est choisi pour que les déplacements parasites se compensent, ce qui constitue une variante avantageuse mais non limitative. Il convient toutefois de remarquer qu'il n'est pas nécessaire de choisir un tel agencement, et un tel oscillateur fonctionne avec deux pivots en série sans pour autant positionner le centre de masse sur l'axe de rotation. Bien sûr, même si les réalisations illustrées correspondent à des configurations géométriques particulières d'alignement, ou de symétrie, on comprend qu'il est aussi possible d'empiler deux pivots différents, ou avec des points de croisement différents, ou avec des centres de masses non alignés, ou encore de mettre en œuvre un nombre supérieur de jeux de lames en série, avec des masses intermédiaires, pour augmenter encore l'amplitude du balancier.

Les variantes illustrées comportent tous les axes de pivotement, croisements de lames, et centres de masse, coplanaires, ce qui est un cas particulier avantageux, mais non limitatif.

On comprend que l'invention permet d'obtenir une course angulaire qui est grande: en tous les cas supérieure à 30°, elle peut même atteindre 50° voire 60°, ce qui la rend compatible en combinaison avec tous les échappements mécaniques usuels, ancre suisse, détente, co-axial, ou autre.

Il s'agit, encore, de déterminer une solution pratique qui soit équivalente à l'utilisation théorique d'une grande valeur du rapport d'aspect des lames.

A cet effet, l'invention subdivise les lames dans le sens de la longueur, en substituant à une lame unique une pluralité de lames élémentaires dont le comportement global soit équivalent, et où chacune des lames élémentaires a un rapport d'aspect limité à une valeur seuil. On diminue ainsi, par rapport à une lame unique de référence, le rapport d'aspect de chaque lame élémentaire, pour retrouver l'optimum d'isochronisme et d'insensibilité aux positions.

Chaque lame 31, 32, a un rapport d'aspect RA = H/E, où H est la hauteur de la lame 31,32, perpendiculairement à la fois au plan d'oscillation et à l'élongation de la lame 31, 32, selon la longueur L, et où E est l'épaisseur de la lame 31, 32, dans le plan d'oscillation et perpendiculairement à l'élongation de la lame 31, 32, selon la longueur L.

Selon l'invention, le rapport d'aspect RA = H/E est inférieur à 10 pour chaque lame 31, 32. Plus particulièrement ce rapport d'aspect est inférieur à 8. Selon l'invention, le nombre total des lames flexibles 31, 32, est strictement supérieur à deux.

Plus particulièrement, l'oscillateur 100 comporte un premier nombre N1 de premières lames appelées lames primaires 31 s'étendant selon une première direction de lame DL1, et un deuxième nombre N2 de premières lames appelées lames secondaires 32 s'étendant selon une deuxième direction de lame DL2, le premier nombre N1 et le deuxième nombre N2 étant chacun supérieur ou égal à deux.

Plus particulièrement, le premier nombre N1 est égal au deuxième nombre N2.

Plus particulièrement encore, l'oscillateur 100 comporte au moins une paire formée d'une lame primaire 31 s'étendant selon une première direction de lame DL1, et d'une lame secondaire 32 s'étendant selon une deuxième direction de lame DL2. Et, dans chaque paire, la lame primaire 31 est identique à la lame secondaire 32 à l'orientation près.

Dans une variante particulière, l'oscillateur 100 ne comporte que des paires chacune formée d'une lame primaire 31 s'étendant selon une première direction de lame DL1, et d'une lame secondaire 32 s'étendant selon une deuxième direction de lame DL2, et, dans chaque paire, la lame primaire 31 est identique à la lame secondaire 32 à l'orientation près.

Dans une autre variante, l'oscillateur 100 comporte au moins un groupe de lames formé d'une lame primaire 31 s'étendant selon une première direction de lame DL1, et d'une pluralité de lames secondaires 32 s'étendant selon une deuxième direction de lame DL2. Et, dans ce cas, dans chaque groupe de lames, le comportement élastique de la lame primaire 31 est identique au comportement élastique résultant du cumul de la pluralité de lames secondaires 32 à l'orientation près.

On remarque encore que, si le comportement d'une lame flexible dépend de son rapport d'aspect RA, il dépend également de la valeur de la courbure qui lui est imprimée. Sa déformée dépend à la fois de la valeur du rapport d'aspect et de la valeur locale du rayon de courbure, notamment à l'encastrement. C'est la raison pour laquelle on adopte, de préférence, une disposition des lames en symétrie en projection plane.

L'invention concerne encore un mouvement d'horlogerie 1000 comportant au moins un tel oscillateur 100 mécanique.

L'invention concerne encore une montre 2000 comportant au moins un tel mouvement d'horlogerie 1000.

Un procédé de fabrication convenable consiste à effectuer, pour les différents types de pivots ci-dessous, les opérations suivantes :

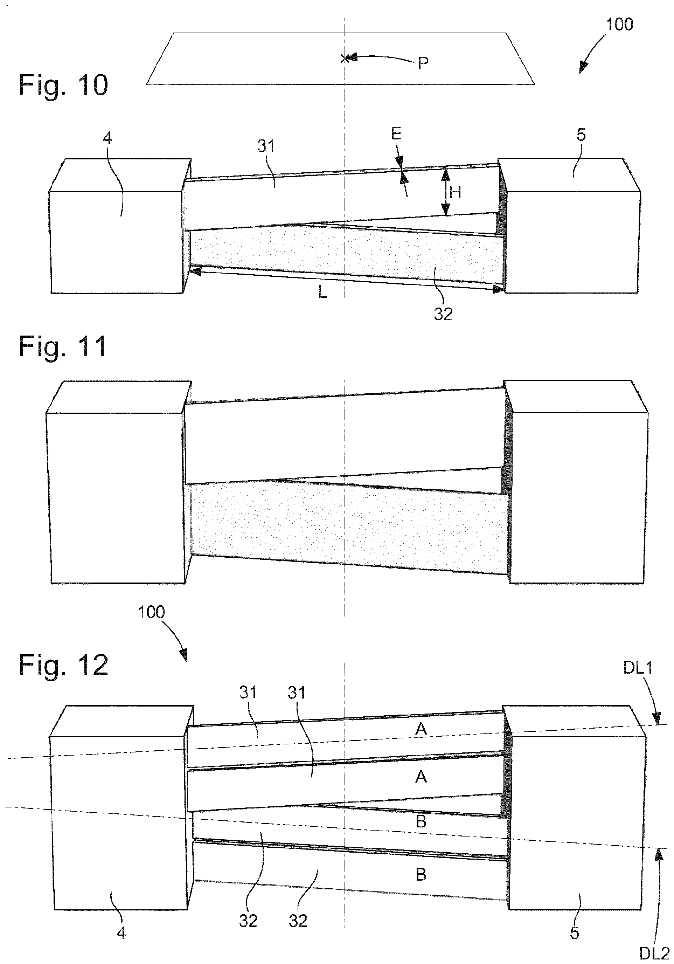

Pour un type de pivot AABB selon le schéma de la figure 12 :

a. utiliser un substrat avec au moins quatre couches, résultant par exemple mais non limitativement de l'assemblage de deux wafers SOI ;
b. graver par procédé de gravure "DRIE" face avant pour obtenir AA, avec notamment gravure des deux couches d'un seul tenant ;
c. graver par procédé de gravure "DRIE" face arrière pour obtenir BB, avec notamment gravure des deux couches d'un seul tenant ;

d. effectuer la séparation partielle des quatre couches par gravure de l'oxyde enterré.

La grande précision du procédé "DRIE", c'est-à-dire gravure ionique réactive profonde (en anglais Deep Reactive Ion Etching DRIE) garantit une très bonne précision en positionnement et en alignement, inférieure ou égale à 5 micromètres, grâce à un alignement optique, ce qui garantit un très bon alignement face à face. Naturellement des procédés équivalents peuvent être mis en oeuvre selon le matériau choisi.

Il est possible de mettre en œuvre des substrats avec un nombre supérieur de couches, notamment un substrat à six couches disponibles, par exemple par assemblage de deux DSOI, pour obtenir une structure de type AAABBB.

Une variante pour l'obtention d'un même type de pivot AABB consiste à :

a. utiliser deux substrats SOI standard à deux couches ;

b. graver par procédé de gravure "DRIE" le premier substrat, sur la face avant pour obtenir A, sur la face arrière pour obtenir A ;

c. graver par procédé de gravure "DRIE" le deuxième substrat, sur la face avant pour obtenir B, sur la face arrière pour obtenir B ; en alternative des opérations b et c on peut, sur le premier substrat et sur le deuxième substrat effectuer la gravure outre des deux couches en une fois, sans effectuer une gravure face avant et face arrière ;

d. effectuer l'assemblage « wafer à wafer » des deux substrats ou « pièce à pièce » des composants individuels, pour obtenir AABB. Le bon alignement des géométries est alors lié à la spécification de la machine de bonding « wafer à wafer » ou au process « pièce à pièce », de façon bien connue de l'homme du métier.

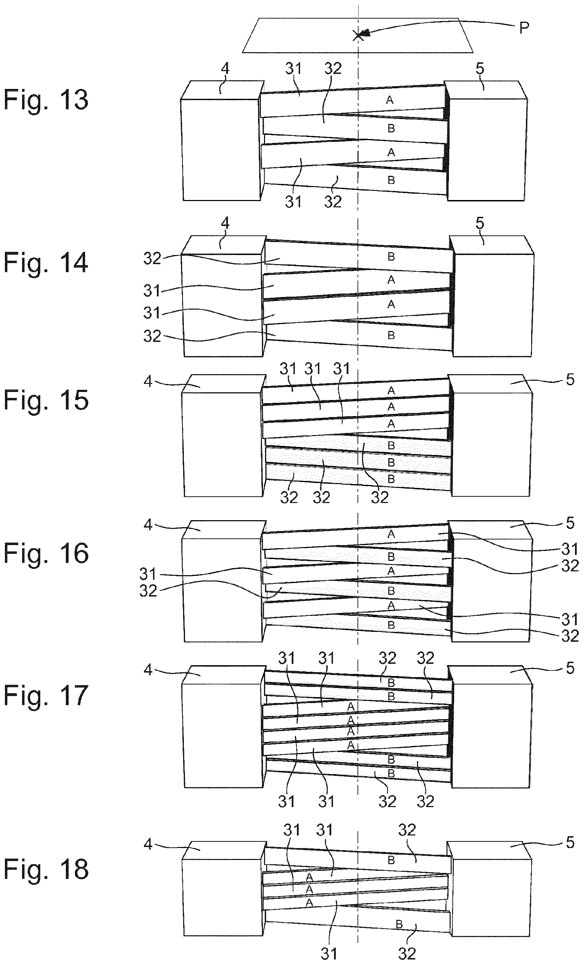

Pour un type de pivot ABAB selon le schéma de la figure 13 :

a. utiliser deux substrats SOI standard à deux couches ;

b. graver par procédé de gravure "DRIE" le premier substrat, sur la face avant pour obtenir A, sur la face arrière pour obtenir B ;

c. graver par procédé de gravure "DRIE" le deuxième substrat, sur la face avant pour obtenir A, sur la face arrière pour obtenir B ;

d. effectuer l'assemblage « wafer à wafer » des deux substrats ou « pièce à pièce » des composants individuels, pour obtenir ABAB. Comme précédemment, Le bon alignement des géométries est lié à la spécification de la machine de bonding « wafer à wafer » ou au process « pièce à pièce ».

Bien d'autres variantes de procédé peuvent être mises en œuvre, selon le nombre de lames et l'équipement disponible.

## Revendications

**1.** Oscillateur mécanique (100) d'horlogerie, comportant, entre un premier élément support rigide (4) et un deuxième élément inertiel massif (5), un guidage flexible comportant plus de deux premières lames flexibles (31 ; 32) qui supportent ledit deuxième élément inertiel massif (5) et sont agencées pour le rappeler vers une position de repos, ledit deuxième élément inertiel massif (5) étant agencé pour osciller angulairement selon un plan d'oscillation autour de ladite position de repos, lesdites premières lames flexibles (31 ; 32) ne se touchant pas et leurs projections sur ledit plan d'oscillation se croisant, en position de repos, en un point de croisement (P), au voisinage duquel ou par lequel passe l'axe de rotation dudit deuxième élément inertiel massif (5) perpendiculairement audit plan d'oscillation, et les encastrements desdites premières lames flexibles (31 ; 32) avec ledit premier élément support rigide (4) et ledit deuxième élément inertiel massif (5) définissant deux directions de lames (DL1 ; DL2) parallèles audit plan d'oscillation, chaque dite lame (31 ; 32) ayant un rapport d'aspect RA = H/E, où H est la hauteur de ladite lame (31 ; 32) perpendiculairement à la fois au plan d'oscillation et à l'élongation de ladite lame (31 ; 32) selon ladite longueur L, et où E est l'épaisseur de ladite lame (31 ; 32) dans le plan d'oscillation et perpendiculairement à l'élongation de ladite lame (31 ; 32) selon ladite longueur L, dans lequel ledit rapport d'aspect RA = H/E est inférieur à 10 pour chaque dite lame (31 ; 32).

**2.** Oscillateur mécanique (100) selon la revendication 1, **caractérisé en ce que** ledit oscillateur (100) comporte un premier nombre N1 de dites premières lames appelées lames primaires (31) s'étendant selon une première direction de lame (DL1), et un deuxième nombre N2 de dites premières lames dites lames secondaires (32) s'étendant selon une deuxième direction de lame (DL2), ledit premier nombre N1 et ledit deuxième nombre N2 étant chacun supérieur ou égal à deux.

**3.** Oscillateur mécanique (100) selon la revendication 2, **caractérisé en ce que** ledit premier nombre N1 est égal audit deuxième nombre N2.

**4.** Oscillateur mécanique (100) selon la revendication 2 ou 3, **caractérisé en ce que** ledit oscillateur comporte au moins une paire formée d'une dite lame primaire (31) s'étendant selon une première direction de lame (DL1), et d'une dite lame secondaire (32) s'étendant selon une deuxième direction de lame (DL2), et **en ce que**, dans chaque paire, ladite lame primaire (31) est identique à ladite lame secondaire (32) à l'orientation près.

**5.** Oscillateur mécanique (100) selon la revendication 4, **caractérisé en ce que** ledit oscillateur ne comporte que des dites paires chacune formée d'une dite lame primaire (31) s'étendant selon une première direction de lame (DL1), et d'une dite lame secondaire (32) s'étendant selon une deuxième direction de lame (DL2), et **en ce que**, dans chaque paire, ladite lame primaire (31) est identique à ladite lame secondaire (32) à l'orientation près.

**6.** Oscillateur mécanique (100) selon la revendication 2 ou 4 selon 2, **caractérisé en ce que** ledit oscillateur comporte au moins un groupe de lames formé d'une dite lame primaire (31) s'étendant selon une première direction de lame (DL1), et d'une pluralité de dite lames secondaires (32) s'étendant selon une deuxième direction de lame (DL2), et **en ce que**, dans chaque dit groupe de lames, le comportement élastique de ladite lame primaire (31) est identique au comportement élastique résultant de ladite pluralité de lames secondaires (32) à l'orientation près.

**7.** Oscillateur mécanique (100) selon l'une des revendications 1 à 6, **caractérisé en ce que** lesdites premières lames (31 ; 32) sont des lames droites.

**8.** Oscillateur mécanique (100) d'horlogerie, selon l'une des revendications 1 à 7, **caractérisé en ce que** lesdites deux directions de lames (DL1 ; DL2) parallèles audit plan d'oscillation font entre elles, en position de repos, en projection sur ledit plan d'oscillation, un angle au sommet a, la position dudit point de croisement (P) étant définie par le rapport X= D/L, où D est la distance entre la projection, sur ledit plan d'oscillation, de l'un des points d'encastrement desdites premières lames (31 ; 32) dans ledit premier élément de support rigide (4) et ledit point de croisement (P), et L est la longueur totale de la projection, sur ledit plan d'oscillation, de ladite lame (31 ; 32) dans son élongation, et **en ce que** ledit rapport d'encastrement (D1/L1 ; D2/L2) est compris entre 0.15 et 0.49, bornes comprises, ou entre 0.51 et 0.85, bornes comprises.

**9.** Oscillateur mécanique (100) selon la revendication 8, **caractérisé en ce que** ledit angle au sommet (a) est inférieur ou égal à 50°, et **caractérisé en ce que** ledit rapport d'encastrement (D1/L1 ; D2/L2) est compris entre 0.25 et 0.75, bornes comprises.

**10.** Oscillateur mécanique (100) selon la revendication 9, **caractérisé en ce que** ledit angle au sommet (a) est inférieur ou égal à 40°, **en ce que** ledit rapport d'encastrement (D1/L1 ; D2/L2) est compris entre 0.30 et 0.70, bornes comprises.

**11.** Oscillateur mécanique (100) selon la revendication 10, **caractérisé en ce que** ledit angle au sommet (a) est inférieur ou égal à 35°, **en ce que** ledit rapport d'encastrement (D1/L1 ; D2/L2) est compris entre 0.40 et 0.60, bornes comprises.

**12.** Oscillateur mécanique (100) selon l'une des revendications 1 à 11, **caractérisé en ce que** ledit angle au sommet (a) est inférieur ou égal à 30°.

**13.** Oscillateur mécanique (100) selon l'une des revendications 1 à 12, **caractérisé en ce que** ledit angle au sommet (a) et ledit rapport X= D/L satisfont la relation :

$$h1(D/L) < \alpha < h2(D/L),$$

avec, pour

$$0.2 \leq X < 0.5 :$$

$$h1(X)= 116 - 473*(X + 0.05) + 3962*(X + 0.05)^3 - 6000*(X + 0.05)^4,$$

$$h2(X)=128 - 473*(X - 0.05) + 3962*(X - 0.05)^3 - 6000*(X - 0.05)^4,$$

pour

$$0.5<X\leq0.8:$$

$$h1(X)= 116 - 473*(1.05 - X) + 3962*(1.05 - X)^3 - 6000*(1.05 - X)^4,$$

$$h2(X)=128 - 473*(0.95 - X) + 3962*(0.95 - X)^3 - 6000*(0.95 - X)^4.$$

14. Oscillateur mécanique (100) selon l'une des revendications 1 à 13, **caractérisé en ce que** le centre de masse dudit oscillateur (100) dans sa position de repos est distant dudit point de croisement (P) d'un écart ($\varepsilon$) qui est compris entre 10% et 20% de la ladite longueur totale L de la projection, sur ledit plan d'oscillation, de ladite lame (31 ; 32).

15. Oscillateur mécanique (100) selon la revendication 14, **caractérisé en ce que** ledit écart ($\varepsilon$) est compris entre 12% et 18% de ladite longueur totale L de la projection, sur ledit plan d'oscillation, de ladite lame (31 ; 32).

16. Oscillateur mecanique (100) selon l'une des ravendications 1 à 15, **caractérisé en ce que** lesdites premières lames (31 ; 32) et leurs encastrements définissent ensemble un pivot (1) qui, en projection sur ledit plan d'oscillation, est symétrique par rapport à un axe de symétrie (AA) passant par ledit point de croisement (P).

17. Oscillateur mécanique (100) selon la revendication 16, **caractérisé en ce que**, en position de repos, en projection sur ledit plan d'oscillation, le centre de masse dudit deuxième élément inertiel massif (5) est situé sur ledit axe de symétrie (AA) dudit pivot (1).

18. Oscillateur mécanique (100) selon la revendication 17, **caractérisé en ce que**, en projection sur ledit plan d'oscillation, le centre de masse dudit deuxième élément inertiel massif (5) est à une distance non nulle dudit point de croisement (P) correspondant à l'axe de rotation dudit deuxième élément inertiel massif (5), laquelle distance non nulle est comprise entre 0.1 fois et 0.2 fois ladite longueur totale L de la projection, sur ledit plan d'oscillation, de ladite lame (31 ; 32).

19. Mouvement d'horlogerie (1000) comportant au moins un oscillateur (100) mécanique selon l'une des revendications 1 à 18.

20. Montre (2000) comportant au moins un mouvement d'horlogerie (1000) selon la revendication 19.

**Patentansprüche**

1. Mechanischer Uhrwerksoszillator (100), aufweisend, zwischen einem ersten starren Halteelement (4) und einem zweiten massiven Trägheitselement (5), eine flexible Führung, die mehr als zwei erste flexible Lamellen (31; 32) aufweist, die das zweite massive Trägheitselement (5) halten und eingerichtet sind, um es in eine Ruhestellung zurückzuholen, wobei das zweite massive Trägheitselement (5) eingerichtet ist, um winklig gemäß einer Oszillationsebene um die Ruhestellung zu oszillieren, wobei sich die ersten flexiblen Lamellen (31; 32) nicht berühren und sich ihre Projektionen auf der Oszillationsebene in Ruhestellung in einem Kreuzungspunkt (P) kreuzen, in der Nähe desselben oder durch den die Rotationsachse des zweiten massiven Trägheitselements (5) senkrecht zur Oszillationsebene verläuft, und die Einpassungen der ersten flexiblen Lamellen (31; 32) mit dem ersten starren Halteelement (4) und dem zweiten massiven Trägheitselement (5) zwei parallele Lamellenrichtungen (DL1; DL2) zu der Oszillationsebene definieren, wobei jede Lamelle (31; 32) ein Seitenverhältnis RA = H/E hat, wobei H die Höhe der Lamelle (31; 32) senkrecht sowohl zur Oszillationsebene als auch zur Schwingungsweite der Lamelle (31; 32) gemäß der Länge L ist und wobei E die Dicke der Lamelle (31; 32) in der Oszillationsebene und senkrecht zur Schwingungsweite der Lamelle (31; 32) gemäß der Länge L ist, wobei das Seitenverhältnis RA = H/E für jede Lamelle (31; 32) kleiner als 10 ist.

2. Mechanischer Oszillator (100) nach Anspruch 1, **dadurch gekennzeichnet, dass** der Oszillator (100) eine ersten Anzahl N1 erster Lamellen aufweist, die als primäre Lamellen (31) bezeichnet werden, die sich gemäß einer ersten Lamellenrichtung (DL1) erstrecken, und eine zweite Anzahl N2 erster Lamellen, die als sekundäre Lamellen (32) bezeichnet werden, die sich gemäß einer zweiten Lamellenrichtung (DL2) erstrecken, wobei die erste Anzahl N1 und die zweite Anzahl N2 jeweils größer oder gleich zwei ist.

3. Mechanischer Oszillator (100) nach Anspruch 2, **dadurch gekennzeichnet, dass** die erste Anzahl N1 gleich der zweiten Anzahl N2 ist.

4. Mechanischer Oszillator (100) nach Anspruch 2 oder 3, **dadurch gekennzeichnet, dass** der Oszillator mindestens ein Paar aufweist, gebildet von einer primären Lamelle (31), die sich gemäß einer ersten Lamellenrichtung (DL1) erstreckt, und einer sekundären Lamelle (32), die sich gemäß einer zweiten Lamellenrichtung (DL2) erstreckt, und dass in jedem Paar die primäre Lamelle (31) mit der sekundären Lamelle (32) identisch ist, von der Ausrichtung abgesehen.

5. Mechanischer Oszillator (100) nach Anspruch 4, **dadurch gekennzeichnet, dass** der Oszillator nur die Paare aufweist, die jeweils von einer primären Lamelle (31) gebildet sind, die sich gemäß einer ersten Lamellenrichtung (DL1) erstreckt, und einer sekundären Lamelle (32), die sich gemäß einer zweiten Lamellenrichtung (DL2) erstreckt, und dass in jedem Paar die primäre Lamelle (31) mit der sekundären Lamelle (32) identisch ist, von der Ausrichtung abgesehen.

6. Mechanischer Oszillator (100) nach Anspruch 2 oder 4 nach 2, **dadurch gekennzeichnet, dass** der Oszillator mindestens eine Lamellengruppe aufweist, die von einer primären Lamelle (31) gebildet ist, die sich gemäß einer ersten Lamellenrichtung (DL1) erstreckt, und einer Vielzahl sekundärer Lamellen (32), die sich gemäß einer zweiten Lamellenrichtung (DL2) erstrecken, und dass in jeder Lamellengruppe das elastische Verhalten der primären Lamelle (31) mit dem elastischen Verhalten identisch ist, das aus der Vielzahl sekundärer Lamellen (32) resultiert, von der Ausrichtung abgesehen.

7. Mechanischer Oszillator (100) nach einem der Ansprüche 1 bis 6, **dadurch gekennzeichnet, dass** die ersten Lamellen (31; 32) gerade Lamellen sind.

8. Mechanischer Uhrwerksoszillator (100) nach einem der Ansprüche 1 bis 7, **dadurch gekennzeichnet, dass** die zwei zu der Oszillationsebene parallelen Lamellenrichtungen (DL1; DL2) zwischen sich in Ruhestellung in Projektion auf die Oszillationsebene einen Winkel an der Spitze a bilden, wobei die Position des Kreuzungspunkts (P) vom Verhältnis X= D/L definiert ist, wobei D der Abstand zwischen der Projektion auf die Oszillationsebene von einem der Einpassungspunkte der ersten Lamellen (31; 32) in das erste starre Halteelement (4) und dem Kreuzungspunkt (P) ist und L die Gesamtlänge der Projektion auf die Oszillationsebene der Lamelle (31; 32) in ihrer Schwingungsweite ist und dass das Einpassungsverhältnis (D1/L1; D2/L2) zwischen 0,15 und 0,49, Grenzen inklusive, oder zwischen 0,51 und 0,85, Grenzen inklusive, liegt.

9. Mechanischer Oszillator (100) nach Anspruch 8, **dadurch gekennzeichnet, dass** der Winkel an der Spitze (a) kleiner oder gleich 50° ist und **dadurch gekennzeichnet, dass** das Einpassungsverhältnis (D1/L1; D2/L2) zwischen 0,25 und 0,75, Grenzen inklusive, liegt.

10. Mechanischer Oszillator (100) nach Anspruch 9, **dadurch gekennzeichnet, dass** der Winkel an der Spitze (a) kleiner oder gleich 40° ist, dass das Einpassungsverhältnis (D1/L1; D2/L2) zwischen 0,30 und 0,70, Grenzen inklusive, liegt.

11. Mechanischer Oszillator (100) nach Anspruch 10, **dadurch gekennzeichnet, dass** der Winkel an der Spitze (a) kleiner oder gleich 35° ist, dass das Einpassungsverhältnis (D1/L1; D2/L2) zwischen 0,40 und 0,60, Grenzen inklusive, liegt.

12. Mechanischer Oszillator (100) nach einem der Ansprüche 1 bis 11, **dadurch gekennzeichnet, dass** der Winkel an der Spitze (a) kleiner oder gleich 30° ist.

**13.** Mechanischer Oszillator (100) nach einem der Ansprüche 1 bis 12, **dadurch gekennzeichnet, dass** der Winkel an der Spitze (a) und das Verhältnis X= D/L dem Verhältnis entspricht:

$$h1(D/L) < \alpha < h2(DL)$$

mit, für

$$0,2 \leq X < 0,5:$$

$$h1(X) = 116 - 473*(X + 0,05) + 3962*(X + 0,05)^3 - 6000*(X + 0,05)^4,$$

$$h2(X) = 128 - 473*(X - 0,05) + 3962*(X - 0,05)^3 - 6000*(X - 0,05)^4,$$

für

$$0,5 < X \leq 0,8:$$

$$h1(X) = 116 - 473*(1,05 - X) + 3962*(1,05 - X)^3 - 6000*(1,05 - X)^4,$$

$$h2(X) = 128 - 473*(0,95 - X) + 3962*(0,95 - X)^3 - 6000*(0,95 - X^4.$$

**14.** Mechanischer Oszillator (100) nach einem der Ansprüche 1 bis 13, **dadurch gekennzeichnet, dass** das Massenzentrum des Oszillators (100) in seiner Ruhestellung vom Kreuzungspunkt (P) um eine Abweichung ($\varepsilon$) entfernt ist, die zwischen 10 % und 20 % der Gesamtlänge L der Projektion der Lamelle (31; 32) auf die Oszillationsebene liegt.

**15.** Mechanischer Oszillator (100) nach Anspruch 14, **dadurch gekennzeichnet, dass** die Abweichung ($\varepsilon$) zwischen 12 % und 18 % der Gesamtlänge L der Projektion der Lamelle (31; 32) auf die Oszillationsebene liegt.

**16.** Mechanischer Oszillator (100) nach einem der Ansprüche 1 bis 15, **dadurch gekennzeichnet, dass** die ersten Lamellen (31; 32) und ihre Einpassungen gemeinsam einen Drehzapfen (1) definieren, der in Projektion auf die Oszillationsebene im Verhältnis zu einer Symmetrieachse (AA), die durch den Kreuzungspunkt (P) verläuft, symmetrisch ist.

**17.** Mechanischer Oszillator (100) nach Anspruch 16, **dadurch gekennzeichnet, dass** sich in Ruhestellung in Projektion auf die Oszillationsebene das Massenzentrum des zweiten massiven Trägheitselements (5) auf der Symmetrieachse (AA) des Drehzapfens (1) befindet.

**18.** Mechanischer Oszillator (100) nach Anspruch 17, **dadurch gekennzeichnet, dass** in Projektion auf die Oszillationsebene das Massenzentrum des zweiten massiven Trägheitselements (5) in einem Abstand ungleich Null vom Kreuzungspunkt (P) ist, der der Rotationsachse des zweiten massiven Trägheitselements (5) entspricht, wobei der Abstand ungleich Null zwischen 0,1 Mal und 0,2 Mal der Gesamtlänge L der Projektion der Lamelle (31; 32) auf die Oszillationsebene liegt.

**19.** Uhrwerk (1000), umfassend mindestens einen mechanischen Oszillator (100) nach einem der Ansprüche 1 bis 18.

**20.** Uhr (2000), aufweisend mindestens ein Uhrwerk (1000) nach Anspruch 19.

**Claims**

**1.** Mechanical timepiece oscillator (100) comprising, between a first rigid support element (4) and a second solid inertial element (5), a flexure bearing including more than two first flexible strips (31; 32) which support said second solid inertial element (5) and are arranged to return said second solid inertial element to a rest position, wherein said second solid inertial element (5) is arranged to oscillate angularly in an oscillation plane about said rest position, said first flexible strips (31; 32) do not touch each other and their projections onto said oscillation plane cross, in the rest position, at a crossing point, in proximity to which or through which passes the axis of rotation of said second solid inertial element (5) perpendicularly to said oscillation plane, and the embedding points of said first flexible strips (31; 32) in said first rigid support element (4) and said second solid inertial element (5) define two strip directions (DL1, DL2) parallel to said oscillation plane, each said strip (31; 32) has an aspect ratio RA = H/E, where H is the height of said strip (31; 32) perpendicularly both to the oscillation plane and to the elongation of said strip (31; 32) along said length L, and wherein E is the thickness of said strip (31; 32) in the oscillation plane and perpendicularly to the elongation of said strip (31; 32) along said length L, wherein said aspect ratio RA = H/E is less than 10 for each said strip (31; 32).

2. Mechanical oscillator (100) according to claim 1, **characterized in that** said oscillator (100) includes a first number N1 of said first said strips, called primary strips (31), extending in a first strip direction (DL1), and a second number N2 of said first strips called secondary strips (32) extending in a second strip direction (DL2), said first number N1 and said second number N2 each being greater than or equal to two.

3. Mechanical oscillator (100) according to claim 2, **characterized in that** said first number N1 is equal to said second number N2.

4. Mechanical oscillator (100) according to claim 2 or 3, **characterized in that** said oscillator includes at least one pair formed of one said primary strip (31) extending in a first strip direction (DL1), and one said secondary strip (32) extending in a second strip direction (DL2) and **in that**, in each pair, said primary strip (31) is identical to said secondary strip (32) except as regards orientation.

5. Mechanical oscillator (100) according to claim 4, **characterized in that** said oscillator includes only said pairs each formed of one said primary strip (31) extending in a first strip direction (DL1), and one said secondary strip (32) extending in a second strip direction (DL2), and **in that**, in each pair, said primary strip (31) is identical to said secondary strip (32), except as regards orientation.

6. Mechanical oscillator (100) according to claim 2 or 4 according to 2, **characterized in that** said oscillator includes at least one group of strips formed of one said primary strip (31) extending in a first strip direction (DL1), and one said secondary strip (32) extending in a second strip direction (DL2) and **in that**, in each said group of strips, the elastic behaviour of said primary strip (31) is identical to the elastic behaviour resulting from said plurality of secondary strips (32) except as regards orientation.

7. Mechanical oscillator (100) according to any of claims 1 to 6, **characterized in that** said first strips (31; 32) are straight strips.

8. Mechanical timepiece oscillator (100) according to any of claims 1 to 7, **characterized in that** said two strip directions (DL1; DL2) parallel to said oscillation plane form therebetween, in the rest position, in projection onto said oscillation plane, a vertex angle a, the position of said crossing point (P) being defined by the ratio X= D/L, where D is the distance between the projection, onto said oscillation plane, of one of the embedding points of said first strips (31; 32) in said first rigid support element (4) and said crossing point (P), and L is the total length of the projection, onto said oscillation plane, of said strip (31; 32) in its elongation, and **in that** said embedding point ratio (D1/L1; D2/L2) is comprised between 0.15 and 0.49 inclusive, or between 0.51 and 0.85 inclusive.

9. Mechanical oscillator (100) according to claim 8, **characterized in that** said vertex angle (a) is less than or equal to 50°, and **characterized in that** said embedding point ratio (D1/L1; D2/L2) is comprised between 0.25 and 0.75 inclusive.

10. Mechanical oscillator (100) according to claim 9, **characterized in that** said vertex angle (a) is less than or equal to 40°, and **in that** said embedding point ratio (D1/L1; D2/L2) is comprised between 0.30 and 0.70 inclusive.

11. Mechanical oscillator (100) according to claim 10, **characterized in that** said vertex angle (a) is less than or equal to 35°, and **in that** said embedding point ratio (D1/L1; D2/L2) is comprised between 0.40 and 0.60 inclusive.

**12.** Mechanical oscillator (100) according to any of claims 1 to 11, **characterized in that** said vertex angle (a) is less than or equal to 30°.

**13.** Mechanical oscillator (100) according to any of claims 1 to 12, **characterized in that** said apex angle (a) and said ratio X= D/L satisfy the relation h1(D/L) < a< h2(D/L), where, for

$$0.2 \leq X < 0.5:$$

$$h1(X) = 116 - 473*(X + 0.05) + 3962*(X + 0.05)^3 - 6000*(X + 0.05)^4,$$

$$h2(X) = 128 - 473*(X - 0.05) + 3962*(X - 0.05)^3 - 6000*(X - 0.05)^4,$$

for

$$0.5 < X \leq 0.8:$$

$$h1(X) = 116 - 473*(1.05 - X) + 3962*(1.05 - X)^3 - 6000*(1.05 - X)^4,$$

$$h2(X) = 128 - 473*(0.95 - X) + 3962*(0.95 - X)^3 - 6000*(0.95 - X)^4.$$

**14.** Mechanical oscillator (100) according to any of claims 1 to 13, **characterized in that** the centre of mass of said oscillator (100) in its rest position is separated from said crossing point (P) by an interval ($\varepsilon$) which is comprised between 10% and 20% of said total length (L) of the projection, onto said oscillation plane, of said strip (31; 32).

**15.** Mechanical oscillator (100) according to claim 14, **characterized in that** said interval ($\varepsilon$) is comprised between 12% and 18% of said total length (L) of the projection, onto said oscillation plane, of said strip (31; 32).

**16.** Mechanical oscillator (100) according to any of claims 1 to 15, **characterized in that** said first strips (31; 32) and their embedding points define together a pivot (1) which, in projection onto said oscillation plane, is symmetrical with respect to an axis of symmetry (AA) passing through said crossing point (P).

**17.** Mechanical oscillator (100) according to claim 16, **characterized in that**, in the rest position, in projection onto said oscillation plane, the centre of mass of said second solid inertial element (5) is located on said axis of symmetry (AA) of said pivot (1).

**18.** Mechanical oscillator (100) according to claim 17, **characterized in that**, in projection onto said oscillation plane, the centre of mass of said second solid inertial element (5) is at a non zero distance from said crossing point (P) corresponding to the axis of rotation of said second solid inertial element (5), which non zero distance is comprised between 0.1 times and 0.2 times said total length (L) of the projection, onto said oscillation plane, of said strip (31; 32).

**19.** Timepiece movement (1000) including at least one mechanical oscillator (100) according to any of claims 1 to 18.

**20.** Watch (2000) including at least one timepiece movement (1000) according to claim 19.

# Fig. 1

# Fig. 2

# Fig. 3

# Fig. 4

# Fig. 5

# Fig. 9

Fig. 6

Fig. 7

Fig. 8

Fig. 10

Fig. 11

Fig. 12

Fig. 13

Fig. 14

Fig. 15

Fig. 16

Fig. 17

Fig. 18

## RÉFÉRENCES CITÉES DANS LA DESCRIPTION

**Documents brevets cités dans la description**

- EP 1419039 A
- EP 16155039 A
- EP 3035127 A1
- US 3628781 A
- EP 2911012 A1
- EP 2998800 A2, PATEK PHILIPPE
- EP 3130966 A1
- CH 709536 A2
- EP 17183666 A
- WO 2016124436 A1

**Littérature non-brevet citée dans la description**

- **M. H. KAHROBAIYAN.** *Congrès de Chronométrie de Montreux,* 28 Septembre 2016